# EUROPEAN PATENT APPLICATION

(11) **EP 3 145 287 A1**
(43) Date of publication of application: **22.03.2017**
(21) Application number: 14895040.5
(22) Date of filing: 15.09.2014
(51) Int. Cl.: H05K 7/20

(54) **HEAT DISSIPATION APPARATUS FOR OPTICAL MODULE AND COMMUNICATION DEVICE USING HEAT DISSIPATION APPARATUS**

(30) Priority: 19.06.2014 CN 201410277436
(71) Applicant: ZTE Corporation, Shenzhen, Guangdong 518057 (CN)
(72) Inventor: GUO, Qian, Shenzhen Guangdong 518057 (CN); LIU, Xiu, Shenzhen Guangdong 518057 (CN); LI, Tingting, Shenzhen Guangdong 518057 (CN); LIANG, Dongdong, Shenzhen Guangdong 518057 (CN); LIN, Weiru, Shenzhen Guangdong 518057 (CN)
(74) Representative: Benson, Christopher
(86) International application number: PCT/CN2014/086562
(87) International publication number: WO 2015/192499

(57) **Abstract**

An heat dissipation device for an optical module, includes a guide rail, herein the guide rail is set on a circuit board for accommodating an optical module, the guide rail is covered with a heat conduction block, heat dissipation teeth are formed in a part of areas on the heat conduction block, the heat dissipation teeth are positioned at a rear portion of the guide rails, the heat dissipation teeth extend in a direction close to the circuit board so that the heat dissipation teeth and the guide rails are positioned at the same side of the heat conduction block. Compared with a structure in which the heat dissipation teeth and the guide rail are positioned at both sides of the heat conduction block, the present invention reduces a height of an assembly of the optical module and effectively solves the problem of the configured height restriction of the assembly of the optical module, it is favorable to the miniaturization of a system, and the present invention further ensures the heat dissipation efficiency of the heat dissipation device through the thermal conduction of the heat conduction block and the heat dissipation of the heat dissipation teeth.

## Description

### Technical Field

The present invention relates to the field of electronic communication, in particular to a heat-dissipation device for an optical module and a communication apparatus utilizing the heat-dissipation device.

### Background

As the design for a system board (also known as a motherboard) is becoming more and more compact and flat, the problem of an occupying rate of a space of the system board has attracted more and more attention. Taking the heat dissipation of a larger device on the system board - an assembly of an optical module for an example, it has become a research hot issue how to design the assembly of the optical module to obtain a better heat dissipation effect and meet the flat and miniaturization requirements of the system board as well.

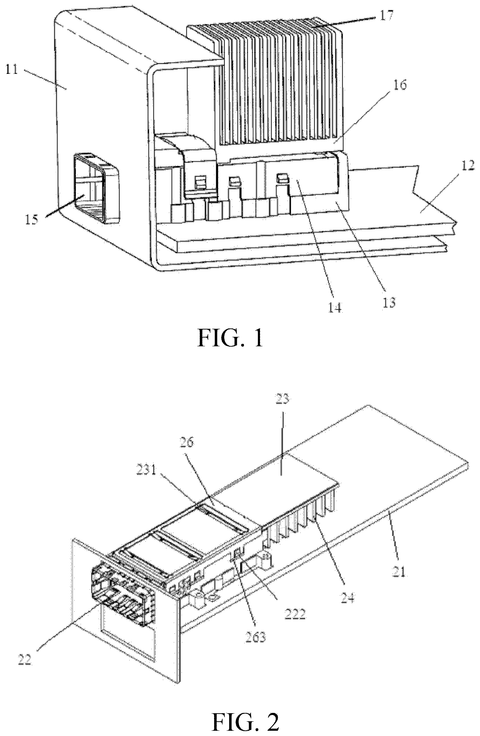

A common a heat-dissipation device for an optical module is shown in FIG. 1, a system board 12 is provided in a space surrounded by an apparatus housing 11, metal guide rails 13 are provided on the system board 12, the optical module is inserted into the metal guide rails 13 through a hole 15 on the apparatus housing 11 to be connected with other hardware (not shown) on the system board 12 and be pulled out when not being used. As shown in FIG. 1, the heat of the optical module is dissipated, a heat-dissipation block 16 is provided on the optical module 14, furthermore, heat dissipation teeth 17 on the heat-dissipation block 16 are away from the optical module 14 and extend upwardly.

This structure causes the height of the assembly of the entire optical module to be increased by several times, as the optical module is the larger device on the system board, this makes the overall space of the system board increase and is not conducive to obtain the goal of miniaturization of the system.

### Summary of the Invention

The technical problem to be solved by the present invention is to provide a heat dissipation device for an optical module and a communication apparatus using the heat dissipation device, which can not only ensure the heat dissipation efficiency and but also effectively solve the problem of the configured height restriction of the assembly of the optical module, thus being conductive to the miniaturization of the system.

To solve the above technical problem, an embodiment of the present invention provides a heat dissipation device for an optical module, including: a guide rail, herein the guide rail is set on a circuit board and used for accommodating the optical module, the guide rail is covered with a heat conduction block, heat dissipation teeth are formed in a part of areas on the heat conduction block, the heat dissipation teeth are positioned at a rear portion of the guide rail, the heat dissipation teeth extend in a direction close to the circuit board so that the heat dissipation teeth and the guide rail are positioned at a same side of the heat conduction block.

To facilitate transfer of heat from the optical module inserted in the guide rail to the heat conduction block, the guide rail is set as a heat conduction guide rail to indirectly transfer heat, or a hole is set on a surface of the guide rail, and the heat conduction block is in contact with the optical module inserted in the guide rail through the hole to directly transfer heat.

When the heat dissipation teeth are made, a height of the heat dissipation teeth is less than a height of the guide rail, so as to provide a gap between the heat dissipation teeth and the circuit board, thus facilitating installation and heat dissipation.

A shape of the heat conduction block is determined according to a heat dissipation intensity and a size of the guide rail accommodating the optical module. For example, in the technical solutions of the present invention, a length of a part of areas of the heat conduction block on which the heat dissipation teeth are formed may be set to be greater than a length of remaining areas of the heat conduction block; in another technical solutions of the present invention, a width of the part of areas of the heat conduction block on which the heat dissipation teeth are formed may be set to be greater than that a width of the remaining areas of the heat conduction block.

A height and an arrangement density of the heat dissipation teeth can also be varied according to actual situations. For example, in the technical solutions of the present invention, the farther the heat dissipation teeth are away from the optical module inserted in the guide rail, the less the height of the heat dissipation teeth is; in other technical solutions of the present invention, the farther the heat dissipation teeth are away from the optical module inserted in the guide rail, the sparser the distribution of the heat dissipation teeth is.

Based on the heat dissipation device for the optical module mentioned above, the heat dissipation device for the optical module of the present invention further includes a fastener, herein the fastener fixes the heat conduction block on the guide rail, and the fastener includes a main plane adapted to a surface of the heat conduction block, two opposite flanks vertical to the main plane formed by extension of two opposite side edges of the main plane, an opening is set on each flank, and the opening matches with the fastener set on the guide rail.

Furthermore, a fastening claw extending toward a hollowed-out space is hollowed out and formed on the main plane, a groove is formed on the surface of the heat conduction block, the fastening claw is fastened in the groove to improve a fastening force of the fastening claw.

Further, the fastening claw may be inclined in a direction of the heat conduction block so as to apply a certain pressure to the heat conduction block to further improve the fastening force of the fastener.

In addition, a transverse rib is formed in the hollowed-out space of the main plane of the fastener, to ensure strength of the fastener.

In another aspect, an embodiment of the present invention further provides a communication apparatus, including an apparatus housing, herein, a circuit board is set in the apparatus housing, a heat dissipation device for an optical module used for dissipating heat of the optical module on the circuit board is set on the circuit board, the heat dissipation device for the optical module is the heat dissipation device for the optical module according to any one of the above technical solutions.

The above technical solutions of the present invention have the following advantageous effects:
for the heat dissipation device for the optical module and the communication apparatus utilizing the heat dissipation device provided in an embodiment of the present invention, the heat dissipation teeth on a heat conduction board are positioned at a rear portion of the guide rail, the heat dissipation teeth extend in a direction close to the circuit board so that the heat dissipation teeth and the guide rail are positioned at the same side of the heat conduction block. Compared with a structure in which the heat dissipation teeth and the guide rail are positioned at both sides of the heat conduction block, the present invention reduces a height of an assembly of the optical module and effectively solves the problem of the configured height restriction of the assembly of the optical module, which is hence favorable to the miniaturization of a system, furthermore, the present invention still ensures the heat dissipation efficiency of the heat dissipation device through the thermal conduction of the heat conduction block and the heat dissipation of the heat dissipation teeth.

### Brief Description of Drawings

FIG. 1 is a diagram of a heat dissipation device for an optical module in the prior art;
Fig. 2 is a diagram of a heat dissipation device for an optical module provided by an embodiment of the present invention;
FIG. 3 is a diagram of guide rails of the heat dissipation device for the optical module shown in FIG. 2;
FIG. 4a is a diagram of a heat conduction block in the heat dissipation device for an optical module shown in FIG. 2;
FIG. 4b is a side diagram of a heat conduction block shown in FIG. 4a;
FIG. 4c and FIG. 4d are diagrams of a variation of the heat conduction block shown in FIG. 4a;
FIG. 4e and FIG. 4f are diagrams of a variation of the heat dissipation teeth shown in FIG. 4b;
FIG. 5 is a diagram of a fastener in a heat dissipation device for an optical module shown in FIG. 2;
FIG. 6 is a diagram that a heat conduction block shown in FIG. 4a is assembled together with a fastener shown in FIG. 5.

### Reference Signs:

In FIG. 1: 11: Apparatus Housing; 12: System Board; 13: Metal Guide Rails; 14: Optical Module; 15: Hole; 16: Heat Dissipation Block; 17: Heat dissipation teeth;
FIG. 2 - FIG. 6: 21: Circuit Board; 22: Guide Rail; 221: Screw Hole; 222: Fastener; 23: Heat Conduction Block; 231: Groove; 24: Heat dissipation teeth; 25: Hole; 26: Fastener; 261: Main plane; 262: Side Surface; 263: Opening; 264: Fastening Claw; 265: Transverse Rib.

### Preferred Embodiments of the Invention

With the combination of drawings and specific embodiments, the present invention will be described in more details in the following:
As shown in FIG. 2, a heat dissipation device for an optical module provided in an embodiment of the present invention includes guide rail 22 for accommodating an optical module (not shown) provided on a circuit board 21, the guide rail 22 may be mounted on the circuit board 21 through a screw hole 221 and other connection structures, the guide rail 22 is covered with a heat conduction block 23, heat dissipation teeth 24 are formed in a part of areas on the heat conduction block 23, the heat dissipation teeth 24 are positioned at a rear portion of the guide rail22 (in FIG. 2, the right side of the guide rails is the rear portion thereof), the heat dissipation teeth 24 extends in a direction close to the circuit board 21 so that the heat dissipation teeth 24 and the guide rails 22 are positioned at the same side of the heat conduction block 23.

In the optical module heat-dissipation device, the heat-dissipating teeth 24 on a heat conduction board 23 are positioned at a rear portion of the guide rail 22, the heat dissipation teeth 24 extends in a direction close to the circuit board 21 so that the heat dissipation teeth 24 and the guide rails 22 are positioned at the same side of the heat conduction block 23, compared with a structure in which the heat dissipation teeth and the guide rail is positioned at both sides of the heat conduction block, the present invention reduces a height of an assembly of the optical module and effectively solves the problem of the configured height restriction of the assembly of the optical module, which is hence favorable to the miniaturization of a system, furthermore, the present invention still ensures the heat dissipation efficiency of the heat dissipation device through the thermal conduction of the heat conduction block and the heat dissipation of the heat dissipation teeth.

In order to facilitate transfer of heat from the optical module inserted in the guide rail 22 to the heat conduction block 23, the guide rail 22 may be provided as a heat conduction guide rail to indirectly transfer heat, at this time, the guide rail 22 is alternatively a metal guide rail with good thermal conduction performance, or a hole 25 may be provided on a surface of the guide rail 22, the heat conduction block 23 is in contact with the optical module inserted in the guide rail 22 through the hole 25 to directly transfer heat.

In addition, a height of the heat dissipation teeth 24 may be less than that of the guide rails 22 when the heat dissipation teeth 24 are made, so as to provide a gap between the heat dissipation teeth 24 and the circuit board 21, which not only facilitates the installation of the heat conduction block 23 but also is conductive to utilizing the gap for heat dissipation, therefore, the dissipated heat may be prevented from being harmful to the other components on the circuit board 21.

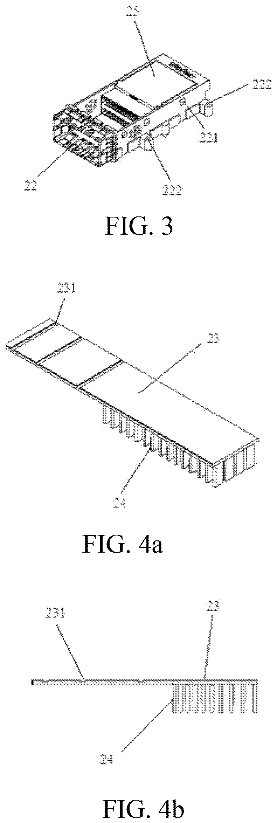

FIG. 4a shows a basic structure of the heat conduction block 23 used in the above-described embodiment of the optical module heat-dissipation device, in actual use, a shape of the heat conduction block 23 in the embodiments of the present invention may be determined in accordance with the heat dissipation intensity and a size of the guide rail 22 for accommodating the optical module, that is, the shape of the heat conduction block 23 may be changed according to actual requirements.

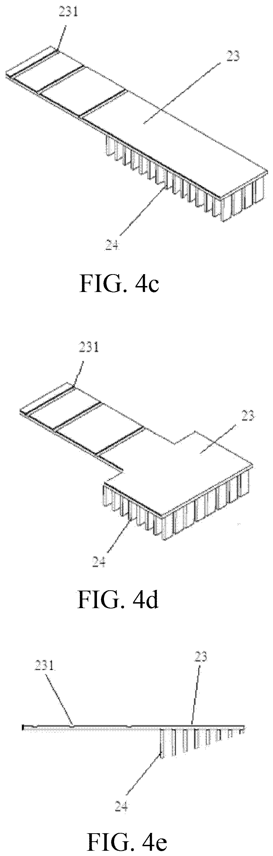

For example, as shown in FIG. 4c, in some embodiments, when the width of the guide rail 22 is small and the heat-dissipation intensity is required to be high, a length of a part of ares of the heat conduction block 23 on which the heat dissipation teeth 24 are formed may be set be larger than that of remaining areas of the heat conduction block 23, that is, the length of the heat conduction block 23 extends in the direction of the rear portion thereof.

For example, as shown in FIG. 4d, in other embodiments, when the width of the guide rails 22 is large and the heat dissipation intensity is required to be high, the width of the partial area of the heat conduction block 23 on which the heat dissipation teeth 24 are formed is set to be bigger than that of the remaining area of the heat conduction block 23, that is, the width of the heat conduction block 23 expands in the direction of both sides.

FIG. 4b shows a basic structure of the heat dissipation teeth 24 used in the above-described embodiments of the optical module heat-dissipation device, in actual use, a height and an arrangement density of the heat dissipation teeth 24 may be changed depending on the actual situation.

For example, as shown in FIG. 4e, in some embodiments, the farther the heat dissipation teeth 24 are away from the optical module inserted in the guide rails 22, the smaller the height of the heat dissipation teeth 24 is, that is, the shorter the heat dissipation teeth 24 may be, this saves material and space.

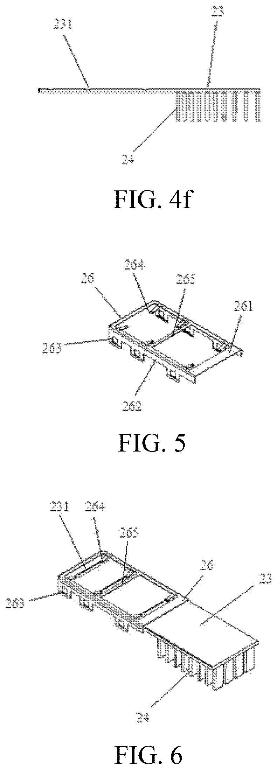

For example, as shown in FIG. 4f, the farther the heat dissipation teeth 24 are away from the optical module inserted in the guide rails 22, the sparse and the looser the distribution of the heat dissipation teeth 24 is, this not only saves material, but also may increase the heat-dissipation effect, therefore, the heat is easy to be transmitted to the external of the heat-dissipation device.

In the practical application, in order to enable the heat conduction block 23 in the heat dissipation device for the optical module to be positioned and fixed on the guide rail 22, a positioning device may be provided to connect the heat conduction block 23 and the guide rail 22 so that the position of the heat conduction block 23 is fixed, and the heat conduction block 23 may also be better in contact with a heating surface of the optical module by the positioning device.

Specifically, the positioning device may be a fastener 26 for fixing the heat conduction block 23 on the guide rail22, the fastener 26 may increase the fastening force between the heat conduction block 23 and the optical module, so that the optical module is in close contact with the heat conduction block 23, thereby improving the heat dissipation effect. As shown in FIG. 5, the fastener 26 includes a main plane 261 adapted to a surface of the heat conduction block 23, two opposite flanks 262 vertical to the main plane 261 starting to extend from opposite side edges of the main plane 261 and are formed, an opening 263 is provided on each flank262, the opening 263 matches with the fastener 222 provided on the guide rail 22, a matching structure is shown in detail in FIG. 2.

The above-described fastener provided on the guide rail 22 may be an elastic component, the opening 263 may be a snap hole on a flank 262 of the fastener 26 that matches with the elastic component. Therefore, the position of the heat conduction block 23 is fixed by the engagement of the elastic component and the snap hole. The fastener 26 in the present embodiment may also be seen as a housing case which matches the guide rails 22 in view of its structure and shape. As shown in FIG. 6, the housing case (i.e., the fastener 26) is first sleeved on the heat conduction block 23 at the time of assembly, and then the opening 263 on the housing case is blocked on the fastener 222 of the guide rails 22, therefore, the housing case is sleeved on an outer surface of the guide rails 22, so that a lower surface of the heat conduction block 23 is better in close contact with the optical module to better achieve heat dissipation.

Furthermore, as shown in FIG. 6, a fastening claw 264 extending toward a hollowed-out space is hollowed out and formed on the main plane 261 of the fastener 26,a groove 231 is formed on the surface of the heat conduction block 23, the fastening claw 264 is fastened in the groove 231 to improve the fastening force of the fastener 26. As shown in FIG. 5, six fastening claws 264 are provided at the hollowed-out edges of the fastener 26 in the drawing. At the same time, the groove 231 matching with the six fastening claws 264 is provided on the heat conduction block 23, the fastening claw 264 and the groove 231 allow the heat conduction block 23 to be closely fastened to the optical module so as to further increase the fastening force between the heat conduction block 23 and the optical module and to further improve the heat dissipation effect of the heat conduction block 23. The number of the fastening claws 264 in the present embodiment may be set in accordance with the actual situation, and may be one or more.

Further, the fastening claw 264 may be inclined in the direction of the heat conduction block 23 so as to have a certain degree of deformation (i.e., have a certain elasticity) so as to apply a certain pressure to the heat conduction block 23 to further enhance the fastening force of the fastener 26.

In addition, the fastener 26 may be provided with a transverse rib 265 to prevent the fastener 26 from being deformed by the larger fastening force while increasing the fastening force of the fastener 26, the transverse rib 26 is provided in the hollow-out space of the main plane 261 of the fastener 26 and connects the edges of the main plane on both sides of the hollow-out space to ensure that the fastener 26 has sufficient strength.

The structure and shape of the heat dissipation device for an optical module in each of the embodiments described above is such that a height of an assembly of the optical module is reduced, but the lateral area occupied by the heat conduction block 23 is increased. Nevertheless, because a main chip is generally around with a passive means with a very low configured height, a user may lay out according to a reasonable layout to ensure that the same density of a means on a single board.

In addition, although it is not shown, an embodiment of the present invention provides a communication apparatus, including an apparatus housing, herein a circuit board is provided in the apparatus housing, an heat dissipation device for an optical module used for dissipating the heat of the optical module thereon is provided on the circuit board, the heat dissipation device for an optical module is the heat dissipation device for an optical module according to any one embodiment.

The above is the alternative embodiments of the present invention, it should be noted that a plurality of improvements and variations may be made by one skilled in the art without departing from the principles of the invention, and such modifications and variations are to be considered within the scope of the present invention.

### Industrial Applicability

For an heat dissipation device for an optical module and a communication apparatus utilizing the heat dissipation device provided in an embodiment of the present invention, heat dissipation teeth on a heat conduction board are positioned at a rear portion of guide rail, the heat dissipation teeth extend in a direction close to the circuit board so that the heat dissipation teeth and the guide rail are positioned at the same side of a heat conduction block. Compared with a structure in which the heat dissipation teeth and the guide rail are positioned at both sides of the heat conduction block, the present invention reduces a height of an assembly of an optical module and effectively solves the problem of the configured height restriction of the assembly of the optical module, which is hence favorable to the miniaturization of a system, furthermore, the present invention still ensures the heat dissipation efficiency of a heat-dissipation device through the thermal conduction of the heat conduction block and the heat dissipation of the heat dissipation teeth.

## Claims

1. A heat dissipation device for an optical module, comprising a guide rail, wherein the guide rail is set on a circuit board and used for accommodating the optical module, the guide rail is covered with a heat conduction block, heat dissipation teeth are formed in a part of areas on the heat conduction block, the heat dissipation teeth are positioned at a rear portion of the guide rail, the heat dissipation teeth extend in a direction close to the circuit board so that the heat dissipation teeth and the guide rail are positioned at a same side of the heat conduction block.

2. The heat dissipation device for the optical module according to claim 1, wherein the guile rail is a heat conduction guide rail; or a hole is set on a surface of the guide rail, the heat conduction block is in contact with the optical module in the guide rail through the hole.

3. The heat dissipation device for the optical module according to claim 1 or 2, wherein a height of the heat dissipation teeth is less than a height of the guide rail, and a gap is set between the heat dissipation teeth and the circuit board.

4. The heat dissipation device for the optical module according to claim 3, wherein a length of the part areas of the heat conduction block on which the heat dissipation teeth are formed is greater than a length of remaining areas of the heat conduction block; or, a width of the part of areas of the heat conduction block on which the heat dissipation teeth are formed is greater than a width of the remaining areas of the heat conduction block.

5. The heat dissipation device for the optical module according to claim 3, wherein the farther the heat dissipation teeth are away from the optical module inserted in the guide rail, the less a height of the heat dissipation teeth is; or, the farther the heat dissipation teeth are away from the optical module inserted in the guide rail, the sparser a distribution of the heat dissipation teeth is.

6. The heat dissipation device for the optical module according to claim 1 or 2, wherein heat dissipation device for the optical module further comprises a fastener, wherein the fastener fixes the heat conduction block on the guide rail, and the fastener comprises a main plane adapted to a surface of the heat conduction block, two opposite flanks vertical to the main plane formed by extension of two opposite side edges of the main plane, and an opening is set on each flank, the opening matches with the fastener set on the guide rail.

7. The heat dissipation device for the optical module according to claim 6, wherein a fastening claw extending toward a hollowed-out space is hollowed out and formed on the main plane, a groove is formed on the surface of the heat conduction block, and the fastening claw is fastened in the groove.

8. The heat dissipation device for the optical module according to claim 7, wherein the fastening claw is inclined in a direction of the heat conduction block.

9. The heat dissipation device for the optical module according to claim 7, wherein a transverse rib is formed in the hollowed-out space of the main plane.

10. A communication apparatus, comprising an apparatus housing, wherein a circuit board is set in the apparatus housing, a heat dissipation device for an optical module used for dissipating heat of the optical module on the circuit board is set on the circuit board, the heat dissipation device is the heat dissipation device for the optical module according to any one of claims 1-9.
